# EUROPEAN PATENT APPLICATION

(11) **EP 4 333 039 A1**
(43) Date of publication of application: **06.03.2024**
(21) Application number: 23186105.5
(22) Date of filing: 18.07.2023
(51) Int. Cl.: H01L 21/822, H01L 21/8234, H01L 27/06, H01L 27/088, H01L 29/66, H01L 29/775, H01L 21/8238, H01L 27/092

(54) **INTEGRATED CIRCUIT DEVICE INCLUDING INTEGRATED INSULATOR AND METHODS OF FABRICATION THE SAME**

(30) Priority: 30.08.2022 US 202263373988 P; 16.03.2023 US 202318184901
(71) Applicant: Samsung Electronics Co., Ltd., Suwon-si, Gyeonggi-do 16677 (KR)
(72) Inventor: YUN, Seungchan, San Jose 95134 (US); SONG, Seungmin, San Jose 95134 (US); JUNG, Myunghoon, San Jose, CA 95134 (US); PARK, Keumseok, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

An integrated circuit device comprises an upper transistor that is on a substrate. The upper transistor comprises an upper channel region (108). The integrated circuit device further comprises a lower transistor that is between the substrate and the upper transistor. The lower transistor comprises a lower channel region (106). The integrated circuit device further includes an integrated insulator (126) that is between the lower channel region and the upper channel region. The integrated insulator comprises an outer layer (129) and an inner layer (127) in the outer layer, wherein the inner layer and the outer layer comprise different materials.

## Description

### BACKGROUND

The present disclosure generally relates to the field of integrated circuit devices and, more particularly, to integrated circuit devices including stacked transistors.

Various structures of an integrated circuit device and methods of forming the same have been proposed to increase the integration density. For example, a stacked transistor structure including multiple transistors vertically stacked has been proposed.

### SUMMARY

An integrated circuit device, according to some embodiments herein, may include an upper transistor that is on a substrate and comprises an upper channel region; a lower transistor that is between the substrate and the upper transistor and comprises a lower channel region; and an integrated insulator that is between the lower channel region and the upper channel region and comprises an outer layer and an inner layer in the outer layer. The inner layer and the outer layer may comprise different materials.

An integrated circuit device, according to some embodiments herein, may include an upper transistor on a substrate, wherein the upper transistor comprises an upper channel region and an upper gate electrode on the upper channel region; a lower transistor between the substrate and the upper transistor, wherein the lower transistor comprises a lower channel region and a lower gate electrode on the lower channel region; and an integrated insulator that is between the lower gate electrode and the upper gate electrode and comprises an inner layer and an outer layer. The inner layer and the outer layer may comprise different materials. The outer layer may extend between the inner layer and the lower gate electrode and between the inner layer and the upper gate electrode.

A method of forming an integrated circuit device, according to some embodiments herein, may include forming an upper channel region of an upper transistor on a substrate; forming a lower channel region of a lower transistor, wherein the lower transistor is between the substrate and the upper transistor; and forming an integrated insulator, wherein the integrated insulator is between the lower channel region and the upper channel region and comprises an outer layer and an inner layer. The inner layer and the outer layer may comprise different materials.

### BRIEF DESCRIPTION OF THE DRAWINGS

FIG. 1 is a plan view of an integrated circuit device according to some embodiments.
FIGS. 1A, 1B, 1C and 1D are example cross-sectional views of the integrated circuit device of FIG. 1 according to some embodiments.
FIG. 2 is a flowchart of methods of forming an integrated circuit device according to some embodiments.
FIGS. 3A through 14D are cross-sectional views illustrating methods of forming an integrated circuit device according to some embodiments.

### DETAILED DESCRIPTION

Pursuant to embodiments herein, an integrated circuit device may include a stacked transistor structure including a lower transistor, an upper transistor vertically stacked on a substrate, and an integrated insulator between the upper transistor and the lower transistor. The integrated insulator may include at least two layers including different materials and may have a thickness at least 10 nanometers (nm). An upper surface of a lower gate electrode of the lower transistor may be at a height between an uppermost end and a lowermost end of the integrated insulator.

Processes of forming a lower electrode of a lower transistor may include etching an upper portion of the lower electrode. When an upper surface of the lower electrode is formed at a height between an uppermost end and a lowermost end of an integrated insulator by that etching, defects that occur during processes of forming the lower electrode and an upper electrode may be reduced. Accordingly, a thick integrated insulator may be beneficial in terms of those defects. It, however, may be difficult to form a thick integrated insulator with a single layer.

Example embodiments will be described in greater detail with reference to the attached figures.

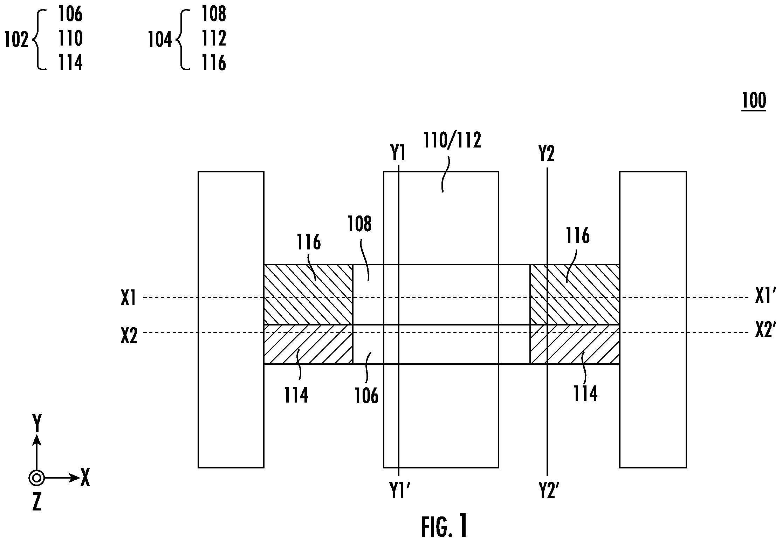

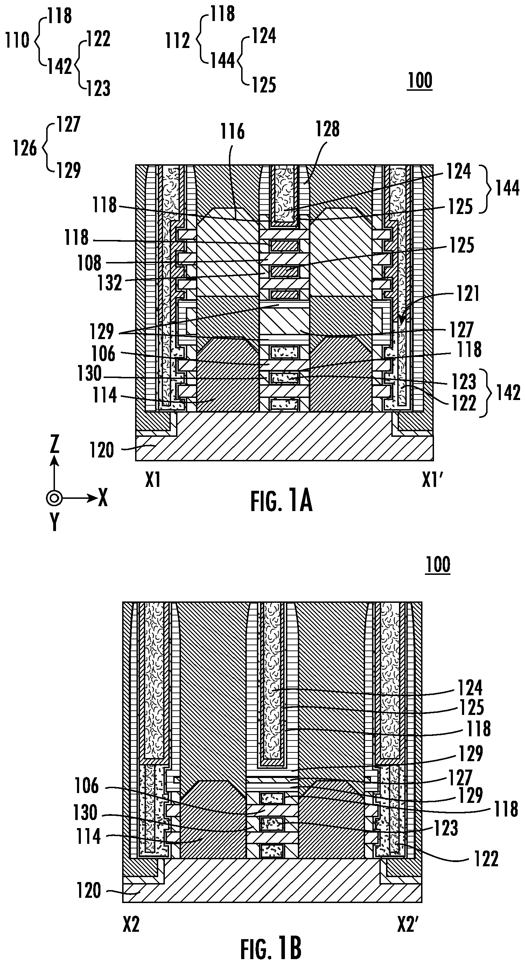

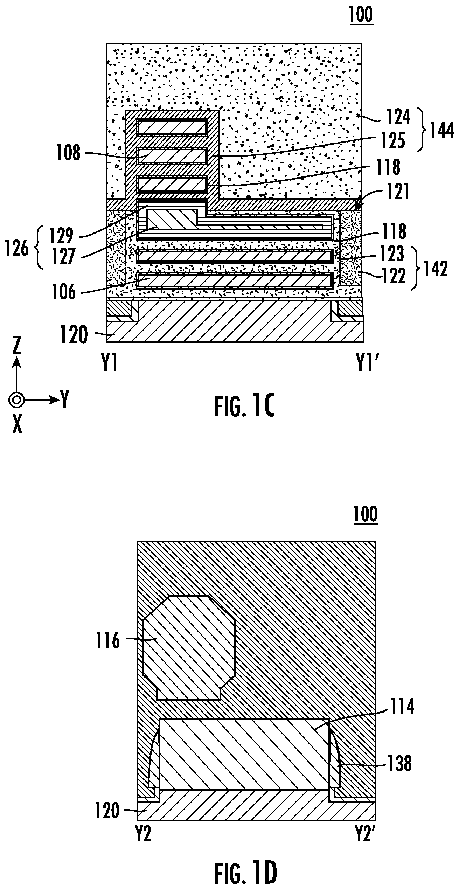

FIG. 1 is a plan view of an integrated circuit device 100 according to some embodiments. FIG. 1A is a cross-sectional view of the integrated circuit device 100 in FIG. 1 taken along line X1-X1'. FIG. 1B is a cross-sectional view of the integrated circuit device 100 in FIG. 1 taken along line X2-X2'. FIG. 1C is a cross-sectional view of the integrated circuit device 100 in FIG. 1 taken along line Y1-Y1'. FIG. 1D is a cross-sectional view of the integrated circuit device 100 in FIG. 1 taken along line Y2-Y2'. Referring to FIGS. 1, 1A, 1B, 1C, and 1D, the integrated circuit device 100 may include a substrate 120, a lower transistor 102 on the substrate 120, an upper transistor 104 on the lower transistor 102. The lower transistor 102 may be between the substrate 120 and the upper transistor 104. The lower transistor 102 may include a lower channel region 106. The upper transistor 104 may include an upper channel region 108. The upper and lower channel regions 108 and 106 may include, for example, a semiconductor material such as silicon (Si). For simplicity of illustration, only one lower transistor 102 and one upper transistor 104 are shown in FIGS. 1A through 1D. In some embodiments, however, the integrated circuit device 100 may include multiple upper transistors and lower transistors.

The integrated circuit device 100 may further include an integrated insulator 126 between the lower transistor 102 and the upper transistor 104 (e.g., between the lower channel region 106 and the upper channel region 108) in a Z-direction (also referred to a vertical direction or a third direction). The integrated insulator may be also referred to as an intergate insulator. The integrated insulator 126 may include multiple layers. For example, the integrated insulator 126 may include an inner layer 127 and an outer layer 129. The outer layer 129 may extend between the inner layer 127 and the upper transistor 104 and between the inner layer 127 and the lower transistor 102. The outer layer 129 may have a uniform thickness along a surface of the inner layer 127. In some embodiments, the outer layer 129 may enclose the inner layer 127 as illustrated in FIG. 1C. The inner layer 127 may include a different material from that of the outer layer 129 such that the inner layer 127 may have etch selectivity with respect to the outer layer 129. For example, the inner layer 127 may include silicon nitride (SiN), and the outer layer 129 may include siliconboron carbonitride (SiBCN) and/or silicon oxycarbonitride (SiOCN). The substrate 120 may include an upper surface facing the lower channel region 106, and the Z-direction may be perpendicular to the upper surface of the substrate 120.

The upper channel region 108 may include a plurality of upper channel regions 108 stacked in the Z-direction. The upper channel regions 108 may be spaced apart from each other in the Z-direction. The upper transistor 104 may further include an upper source/drain region 116 that is electrically connected to and/or is in contact with the upper channel regions 108. The upper channel regions 108 may be disposed between a pair of the upper source/drain regions 116 that are spaced apart from each other in a X-direction (also referred to as a first horizontal direction or a first direction). The X-direction may be parallel to the upper surface of the substrate 120 and may be perpendicular to the Z-direction.

Likewise, the lower channel region 106 may include a plurality of lower channel regions 106 stacked in the Z-direction. The lower channel regions 106 may be spaced apart from each other in the Z-direction. The lower transistor 102 may further include a lower source/drain region 114 that is electrically connected to and/or is in contact with the lower channel regions 106. The lower channel regions 106 may be disposed between a pair of the lower source/drain regions 114 that are spaced apart from each other in the X-direction. Each of the upper channel region 108 and the lower channel region 106 may include, for example, semiconductor material(s) (e.g., Si, Ge, SiGe, GaP, GaAs, SiC, SiGeC, and/or InP). Each of the upper channel regions 108 and the lower channel regions 106 may be a nanosheet that may have a thickness in a range of from 1 nm to 100 nm in the Z-direction or may be a nanowire that may have a circular cross-section with a diameter in a range of from 1 nm to 100 nm.

In some embodiments, the upper source/drain region 116 may include a different semiconductor material from that of the lower source/drain region 114. For example, the upper source/drain region 116 may include silicon germanium (SiGe), and the lower source/drain region 114 may include silicon (Si).

The upper transistor 104 may further include an upper gate structure 112 on the upper channel regions 108. The upper gate structure 112 may include an upper gate electrode 144 that may include an upper gate metal 124 and an upper work function layer 125. In some embodiments, a portion of the upper work function layer 125 may fill a space between two adjacent upper channel regions 108. Likewise, the lower transistor 102 may further include a lower gate structure 110 on the lower channel regions 106. The lower gate structure 110 may include a lower gate electrode 142 that may include a lower gate metal 122 and a lower work function layer 123. In some embodiments, a portion of the lower work function layer 123 may fill a space between two adjacent lower channel regions 106.

Each of the upper gate metal 124 and the lower gate metal 122 may include, for example, tungsten (W), aluminum (Al) and/or copper (Cu). In some embodiments, each of the upper gate metal 124 and the lower gate metal 122 may include a tungsten layer. In some embodiments, the upper transistor 104 and the lower transistor 102 may have different conductivity types. In some embodiments, the upper transistor 104 may be a p-type transistor, and the upper work function layer 125 may include a p-type work function layer (e.g., TiN layer). In some embodiments, the lower transistor 102 may be an n-type transistor, and the lower work function layer 123 may include an n-type work function layer (e.g., TiC layer, TiAl layer and/or TiAlC layer). Each of the lower work function layer 123 and the upper work function layer 125 may be a single layer or may include multiple layers.

In some embodiments, the integrated insulator 126 may be disposed between the upper gate electrode 144 and the lower gate electrode 142. The outer layer 129 may extend between the inner layer 127 and the upper gate electrode 144 and between the inner layer 127 and the lower gate electrode 142.

Referring to FIG. 1C, in some embodiments, an upper portion of the integrated insulator 126 may be in the upper gate electrode 144, and a lower portion of the integrated insulator 126 may be in the lower gate electrode 142. The upper portion of the integrated insulator 126 may protrude upwardly beyond an upper surface 121 of the lower gate electrode 142. The upper surface 121 of the lower gate electrode 142 may be lower than an uppermost end of the integrated insulator 126. The lower portion of the integrated insulator 126 in the lower gate electrode 142 may have a width in a Y-direction (also referred to as a second horizontal direction or a second direction) similar to a width of the lower channel region 106 in the Y-direction and may be wider than a width of the upper portion of the integrated insulator 126 in the Y-direction. In some embodiments, a width of the upper channel region 108 in the Y-direction may be similar to the width of the upper portion of the integrated insulator 126 in the Y-direction. The Y-direction may be parallel to the upper surface of the substrate 120 and may be perpendicular to the X-direction.

The upper gate structure 112 may further include a portion (e.g., an upper portion) of a gate insulator 118 extending between the upper gate electrode 144 and the upper channel region 108. Likewise, the lower gate structure 110 may further include a portion (e.g., a lower portion) of the gate insulator 118 extending between the lower gate electrode 142 and the lower channel region 106.

For example, the gate insulator 118 may include an interfacial layer and a high-k material layer sequentially stacked on the upper channel region 108 and the lower channel region 106. For example, the interfacial layer may be a silicon oxide layer, and the high-k material layer may include hafnium silicate, zirconium silicate, hafnium dioxide and/or zirconium dioxide.

The upper transistor 104 may further include an upper inner spacer layer 132. The upper inner spacer layer 132 may be disposed between the upper source/drain region 116 and the upper gate structure 112, which are spaced apart from each other in the X-direction. In addition, the upper inner spacer layer 132 may be disposed between the upper channel regions 108, which are spaced apart from each other in the Z-direction.

Likewise, the lower transistor 102 may further include a lower inner spacer layer 130. The lower inner spacer layer 130 may be disposed between the lower source/drain region 114 and the lower gate structure 110, which are spaced apart from each other in the X-direction. In addition, the lower inner spacer layer 130 may be disposed between the lower channel regions 106, which are spaced apart from each other in the Z-direction.

As shown in FIG. 1A, a sidewall of the upper inner spacer layer 132 may be in contact with the upper source/drain region 116. Likewise, a sidewall of the lower inner spacer layer 130 may be in contact with the lower source/drain region 114.

The upper inner spacer layer 132 may include a different material that of the outer layer 129. In some embodiments, the upper inner spacer layer 132 may include the same material that of the inner layer 127. For example, the upper inner spacer layer 132 may include silicon nitride (SiN). The upper inner spacer layer 132 may be in contact with the integrated insulator 126 (e.g., an upper surface of the integrated insulator 126). For example, the upper inner spacer layer 132 (e.g., a lower surface of the upper inner spacer layer 132) may be in contact with the outer layer 129 of the integrated insulator 126.

Likewise, the lower inner spacer layer 130 may include a different material that of the outer layer 129. In some embodiments, the lower inner spacer layer 130 may include the same material that of the inner layer 127. For example, the lower inner spacer layer 130 may include silicon nitride (SiN). The lower inner spacer layer 130 may be in contact with the integrated insulator 126 (e.g., a lower surface of the integrated insulator 126). For example, the lower inner spacer layer 130 (e.g., an upper surface of the lower inner spacer layer 130) may be in contact with the outer layer 129 of the integrated insulator 126.

According to some embodiments, the upper transistor 104 may further include a gate spacer 128 on a side surface of an upper portion of the upper gate structure 112. For example, the gate spacer 128 may be on a side surface of the upper gate electrode 144. A portion of the gate insulator 118 may be disposed between the side surface of the upper gate electrode 144 and the gate spacer 128. The gate spacer 128 may be in contact with the upper gate structure 112. For example, the gate spacer 128 may be in contact with a side wall of the gate insulator 118.

According to some embodiments, the upper inner spacer layer 132 may be disposed between the integrated insulator 126 and the gate spacer 128, which are spaced apart from each other in the Z-direction. The gate spacer 128 and the outer layer 129 may include a same material. For example, each of the gate spacer 128 and the outer layer 129 may include SiBCN and/or SiOCN.

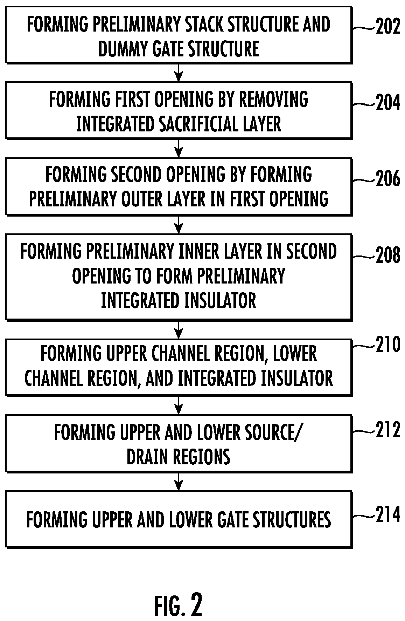

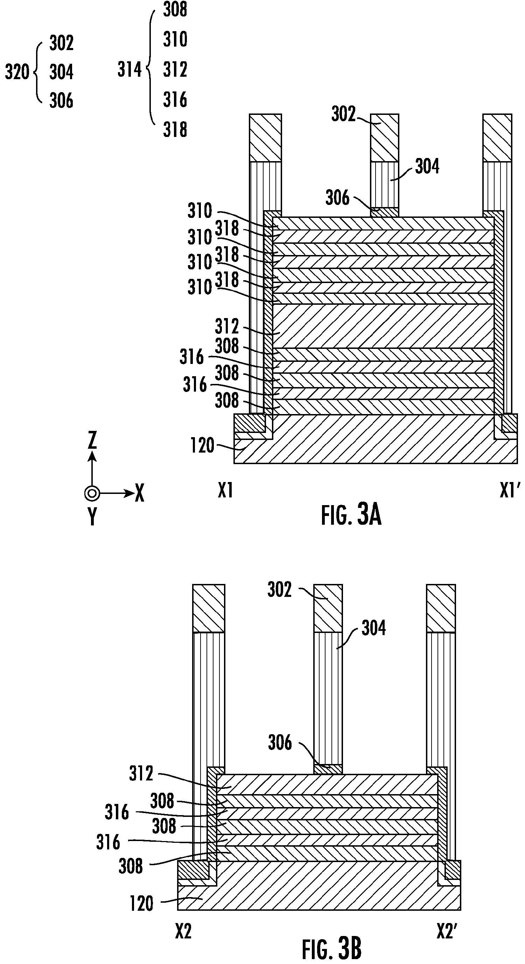

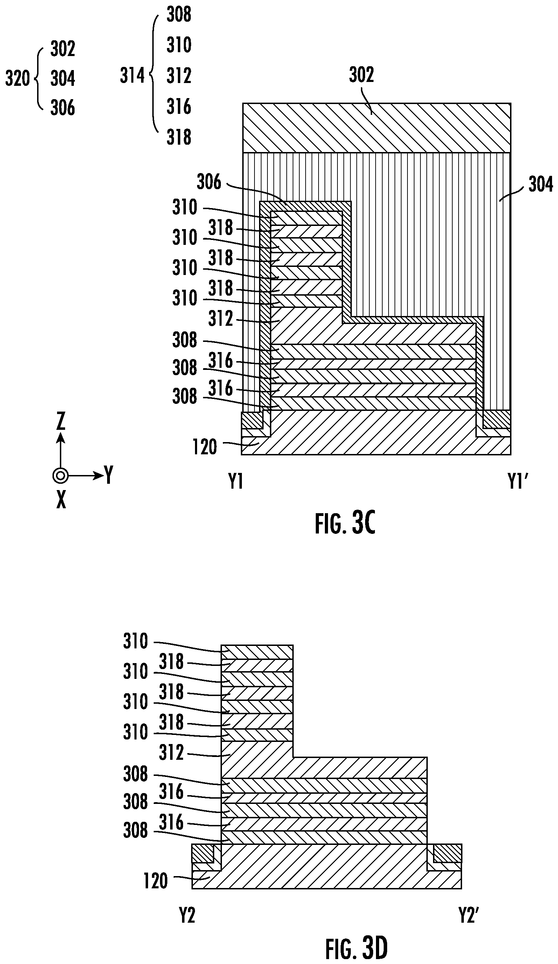

FIG. 2 is a flowchart of methods of forming the integrated circuit device 100 of FIG. 1 according to some embodiments. FIGS. 3A through 14D are cross-sectional views illustrating methods of forming the integrated circuit device 100 of FIG. 1 according to some embodiments.

As shown in FIGS. 3A to 3D, the methods may include forming a preliminary stack structure 314 and a dummy gate structure 320 on a substrate 120 (Block 202).

The preliminary stack structure 314 may include a lower channel layer 316 and an upper channel layer 318. The lower channel layer 316 may include a plurality of lower channel layers 316. The upper channel layer 318 may include a plurality of upper channel layers 318.

The preliminary stack structure 314 may also include a plurality of lower sacrificial layers 308 formed on the substrate 120 and a plurality of upper sacrificial layers 310 formed on the lower sacrificial layers 308. The lower sacrificial layers 308 may be alternately stacked with the lower channel layers 316. Likewise, the upper sacrificial layers 310 may be alternately stacked with the upper channel layers 318.

An intergate sacrificial layer 312 may be formed between the lower sacrificial layers 308 and the upper sacrificial layers 310. The intergate sacrificial layer 312 may have a larger thickness than each of the lower and upper channel layers 316 and 318, and each of the lower and upper sacrificial layers 308 and 310 in the Z-direction. In some embodiments, a thickness of the intergate sacrificial layer 312 in the vertical direction may be at least 10 nm. For example, the intergate sacrificial layer 312 may be at least 12.5 nm or at least 20 nm.

The lower channel layers 316, the upper channel layers 318, and the intergate sacrificial layer 312 may be semiconductor layers that include, for example, silicon (Si). In subsequent processes, the upper sacrificial layers 310 and the lower sacrificial layers 308 may be selectively removed with respect to the lower and upper channel layers 316 and 318 and thus may include material(s) different from the lower and upper channel layers 316 and 318. The upper and lower sacrificial layers 310 and 308 may include, for example, silicon germanium (SiGe).

The dummy gate structure 320 may be formed on the preliminary stack structure 314. For example, the dummy gate structure 320 may traverse the upper channel layers 318 in the Y-direction. The dummy gate structure 320 may include a dummy gate insulator 306 on the upper channel layers 318, a dummy gate layer 304 on the dummy gate insulator 306, and a dummy gate mask 302 on the dummy gate layer 304. For example, the dummy gate insulator 306 may include oxide (e.g., SiO₂), the dummy gate layer 304 may v silicon (Si), and the dummy gate mask 302 may include silicon nitride (SiN).

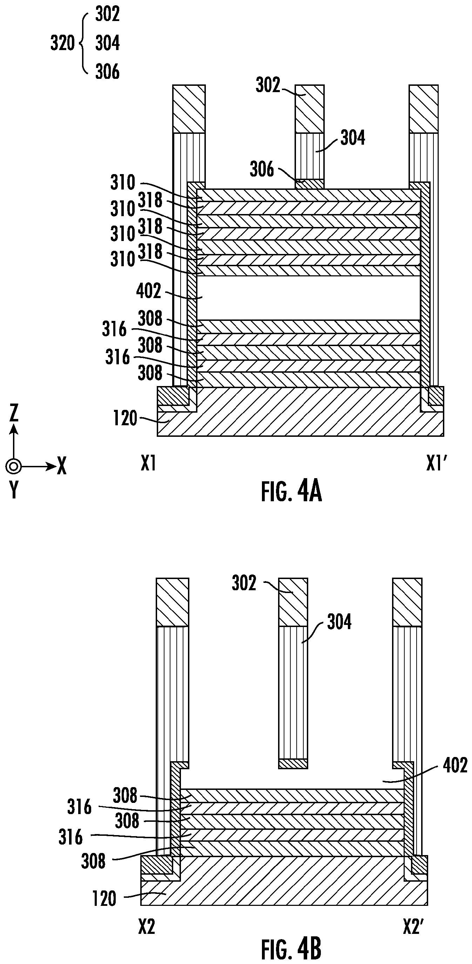

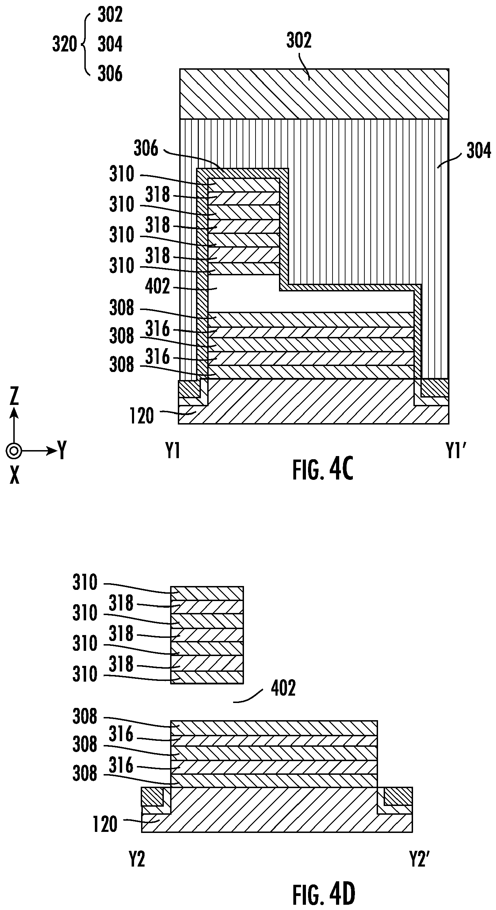

As shown in FIGS. 4A to 4D, the intergate sacrificial layer 312 may be removed to form a first opening 402 (Block 204). The intergate sacrificial layer 312 may be removed by etch process(es) (e.g., a wet etch process and/or a dry etch process). In some embodiments, the intergate sacrificial layer 312 may be wet etched with an etchant including, for example, ammonia.

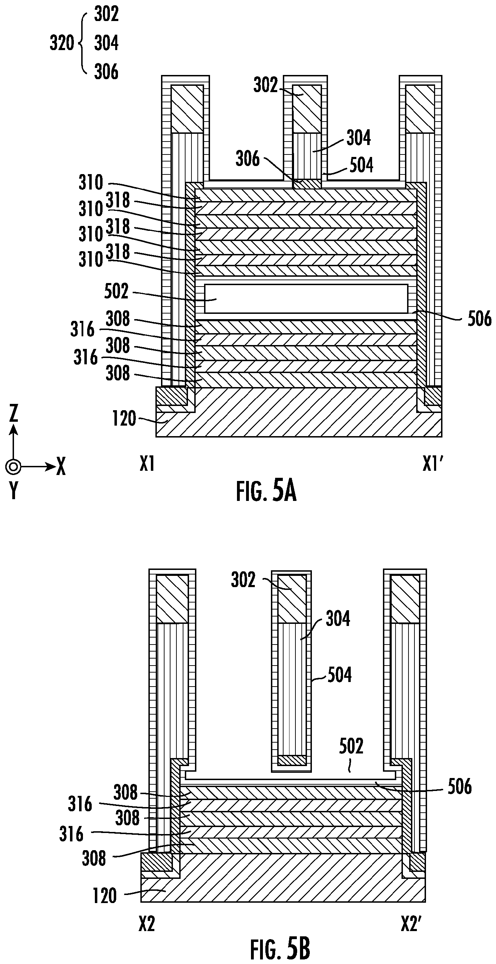

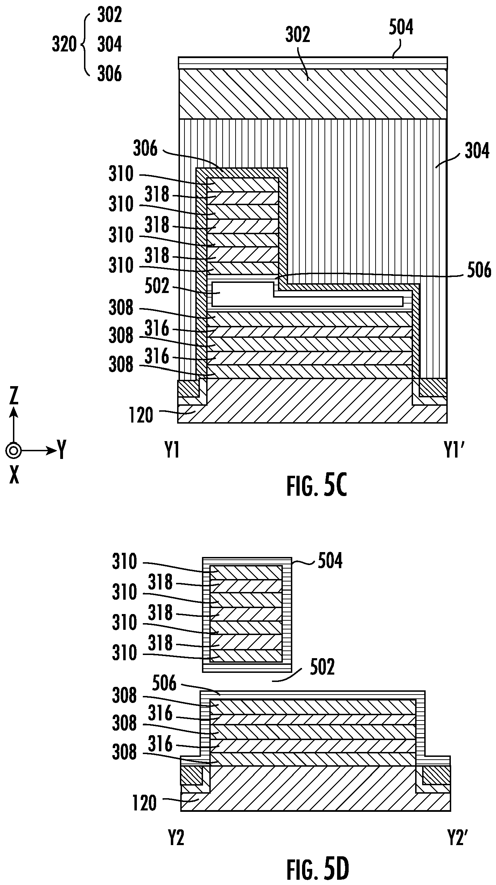

As shown in FIGS. 5A to 5D, a first spacer layer 504 may be formed on the preliminary stack structure 314, on the dummy gate structure 320 and in the first opening 402, thereby forming a second opening 502 in the first opening 402 (Block 206). The first spacer layer 504 may be conformally formed on a top surface and side surfaces of the dummy gate structure 320. A portion of the first spacer layer 504 formed in the first opening 402 may form a preliminary outer layer 506. The first spacer layer 504 may include, for example, siliconboron carbonitride (SiBCN) and/or silicon oxycarbonitride (SiOCN). The preliminary outer layer 506 may be conformally formed along inner surfaces of the first opening 402 and may have a uniform thickness along the inner surfaces of the first opening 402.

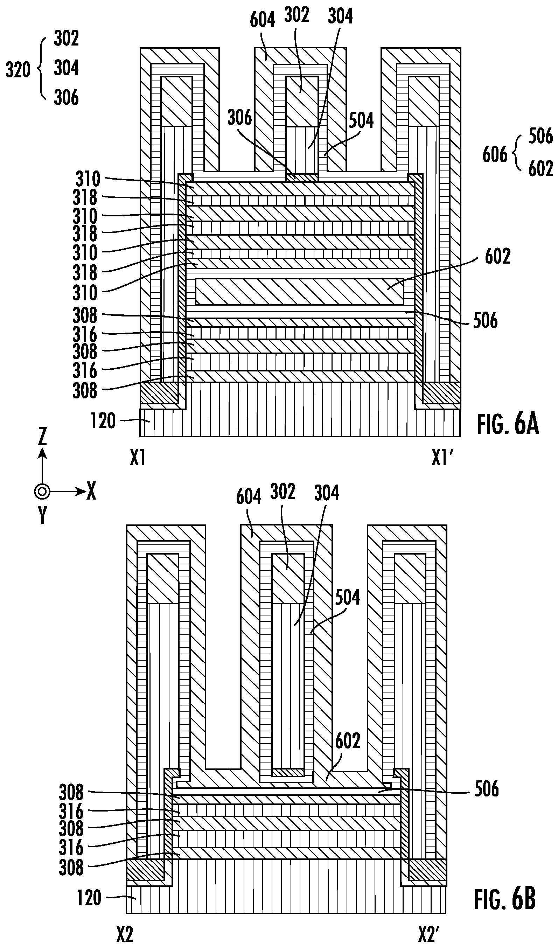

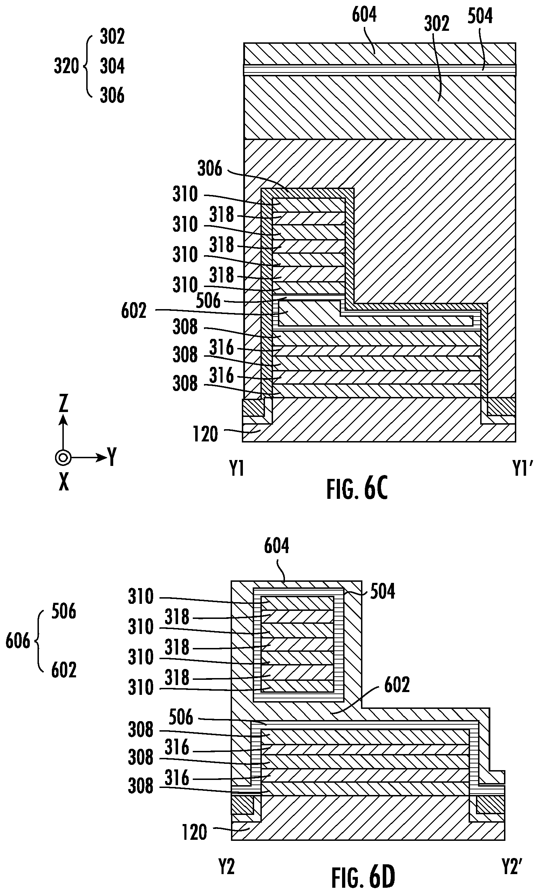

As shown in FIGS. 6A to 6D, a second spacer layer 604 may be formed on the first spacer layer 504 and in the second opening 502, thereby forming a preliminary inner layer 602 in the second opening 502 (Block 208). The second spacer layer 604 may be on a top surface and side surfaces of the dummy gate structure 320. The first spacer layer 504 may extends between the dummy gate structure 320 and the second spacer layer 604. A portion of the second spacer layer 604 formed in the second opening 502 may form the preliminary inner layer 602. The second spacer layer 604 may include a material different from that of the first spacer layer 504. For example, the second spacer layer 604 may include silicon nitride (SiN). In some embodiments, the preliminary inner layer 602 may completely fill the second opening 502, as illustrated in FIG. 6A. The preliminary outer layer 506 and the preliminary inner layer 602 may form a preliminary integrated insulator 606.

In some embodiments, the second spacer layer 604 formed by a single deposition process may not be thick enough to completely fill the second opening 502, and multiple deposition processes may be performed to completely fill the second opening 502 with second spacer layers 604. In some embodiments, when multiple deposition processes are performed to form the second spacer layers 604, the second spacer layer 604 formed on the dummy gate structure 320 may be removed after each deposition process until the first spacer layer 504 is exposed.

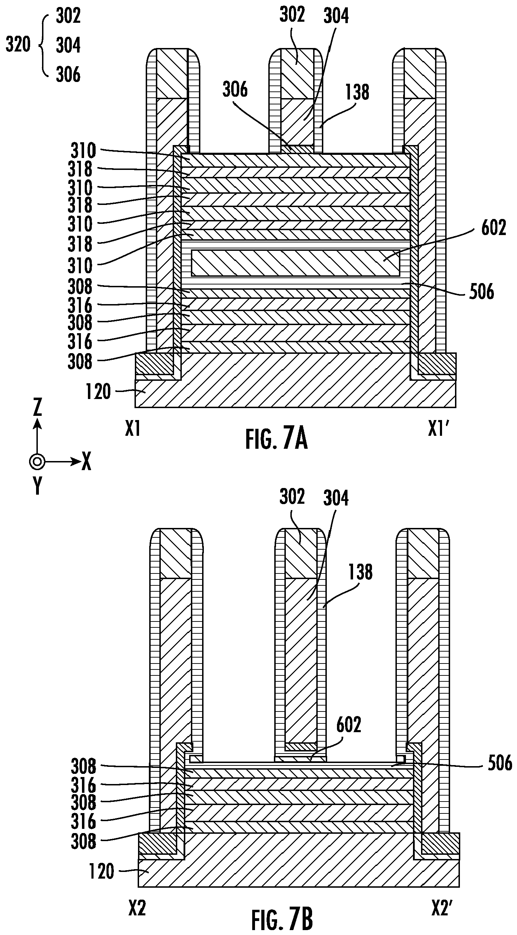

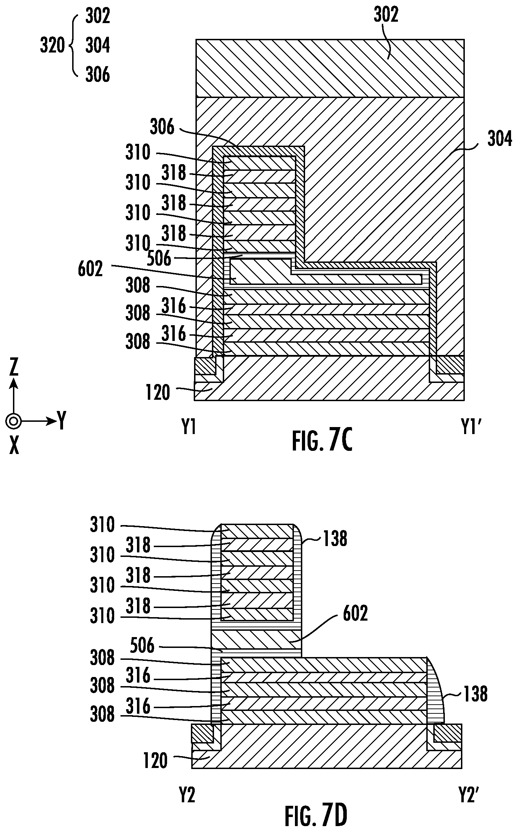

As shown in FIGS. 7A to 7D, the second spacer layer 604 formed on the dummy gate structure 320 may be removed to expose the first spacer layer 504, and then an etch process (e.g., anisotropic etch process) may be performed on the first spacer layer 504. That etch process may leave portions of the first spacer layer 504 on opposing side surfaces of the dummy gate structure 320, thereby forming the first spacers 138.

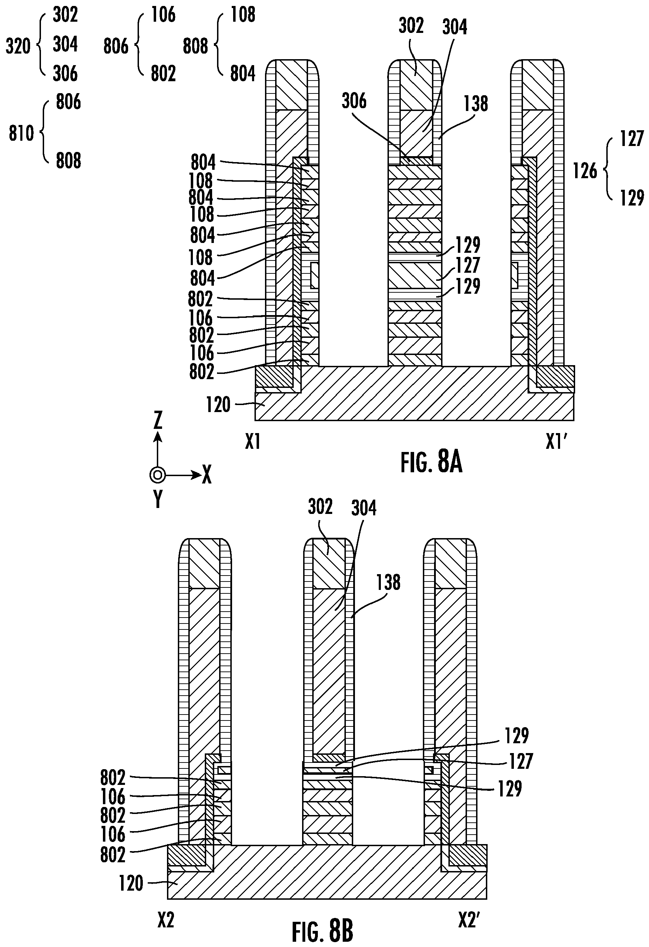

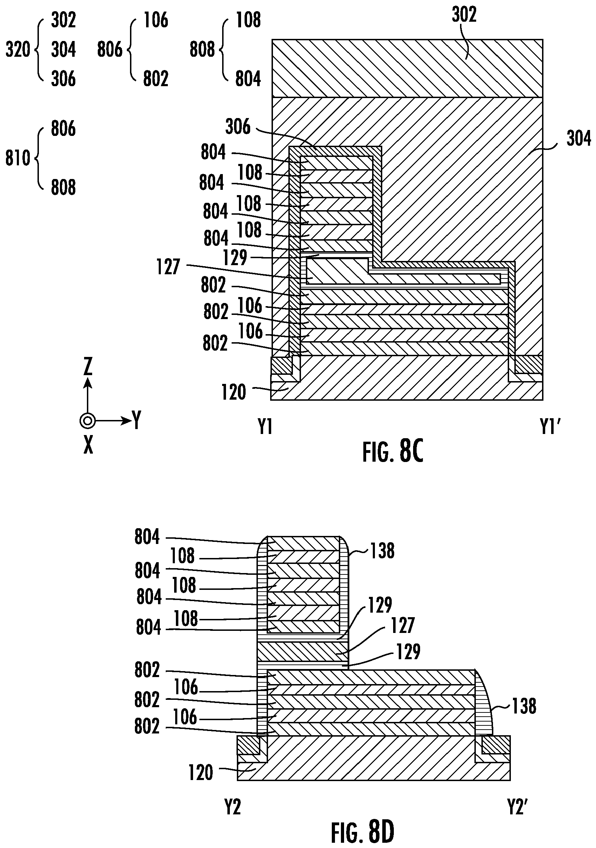

As shown in FIGS. 8A to 8D, an etch process may be performed on the preliminary stack structure 314 using the dummy gate structures 320 and the first spacers 138 formed on sidewall of the dummy gate structures 320 as an etch mask, thereby forming upper channel regions 108, lower channel regions 106 and an integrated insulator 126 (Block 210). The etch process may be a single process or multiple processes. The upper channel region 108 may be a portion of the upper channel layer 318, and the lower channel region 106 may be a portion of the lower channel layer 316. The integrated insulator 126 may include an inner layer 127, a portion of the preliminary inner layer 602, and an outer layer 129, a portion of the preliminary outer layer 506. Further, a plurality of upper sacrificial patterns 804 may be formed from the upper sacrificial layers 310, and a plurality of lower sacrificial patterns 802 may be formed from the lower sacrificial layers 308. That etch process may form an upper stack 808 including the upper channel regions 108 and the upper sacrificial patterns 804 and a lower stack 806 including the lower channel regions 106 and the lower sacrificial patterns 802. The lower channel regions 106 may be stacked alternately with the lower sacrificial patterns 802. The upper channel regions 108 may be stacked alternately with the upper sacrificial patterns 804. The lower stack 806, the upper stack 808, and the integrated insulator 126 may form a stack structure 810.

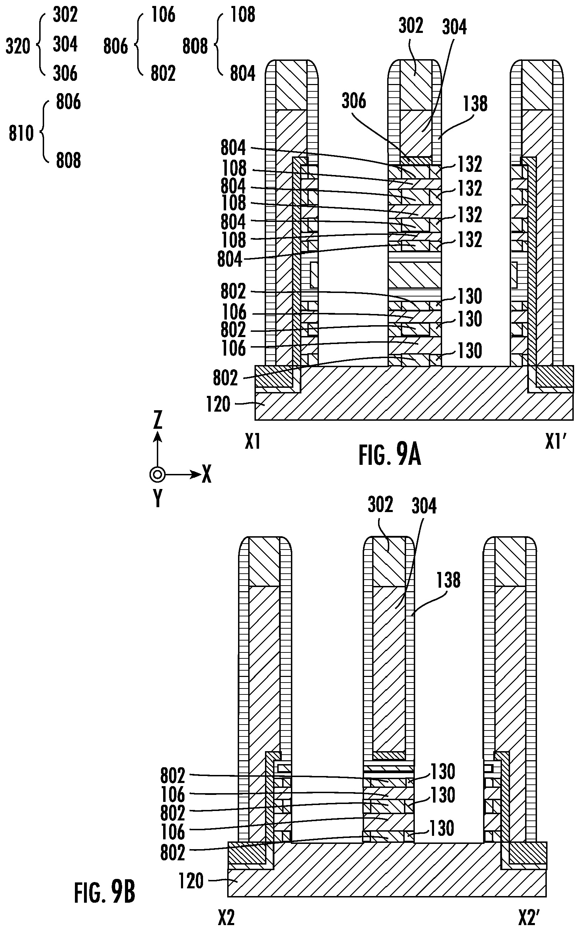

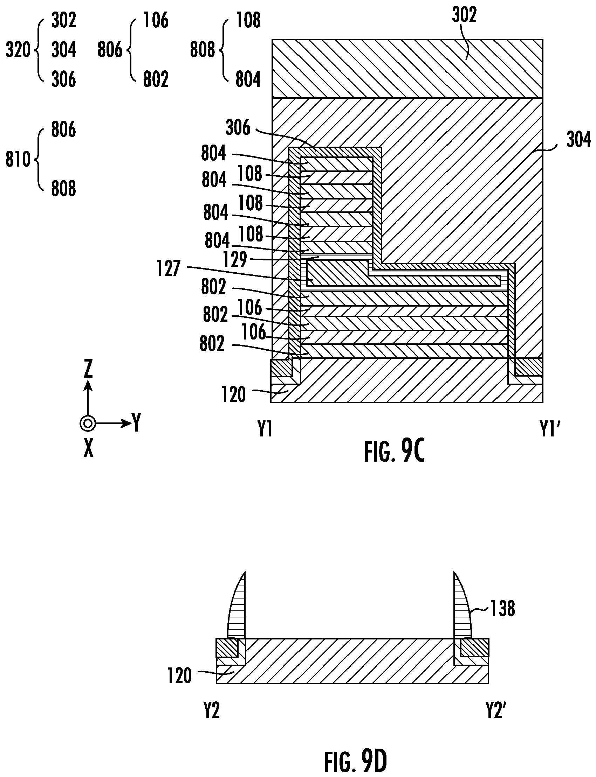

As shown in FIGS. 9A to 9D, the upper inner spacer layer 132 may be formed on sidewalls of the upper sacrificial patterns 804, and the lower inner spacer layer 130 may be formed on sidewalls of the lower sacrificial patterns 802. In some embodiments, portions of the upper sacrificial patterns 804 and the lower sacrificial patterns 802 may be removed to form recesses on the sidewalls of the upper sacrificial patterns 804 and on the sidewalls of the lower sacrificial patterns 802 and then the upper inner spacer layer 132 and the lower inner spacer layer 130 may be formed in those recesses. The upper inner spacer layer 132 and the lower inner spacer layer 130 may include a same material (e.g., SiN). The upper inner spacer layer 132 may include a same material that of the inner layer 127.

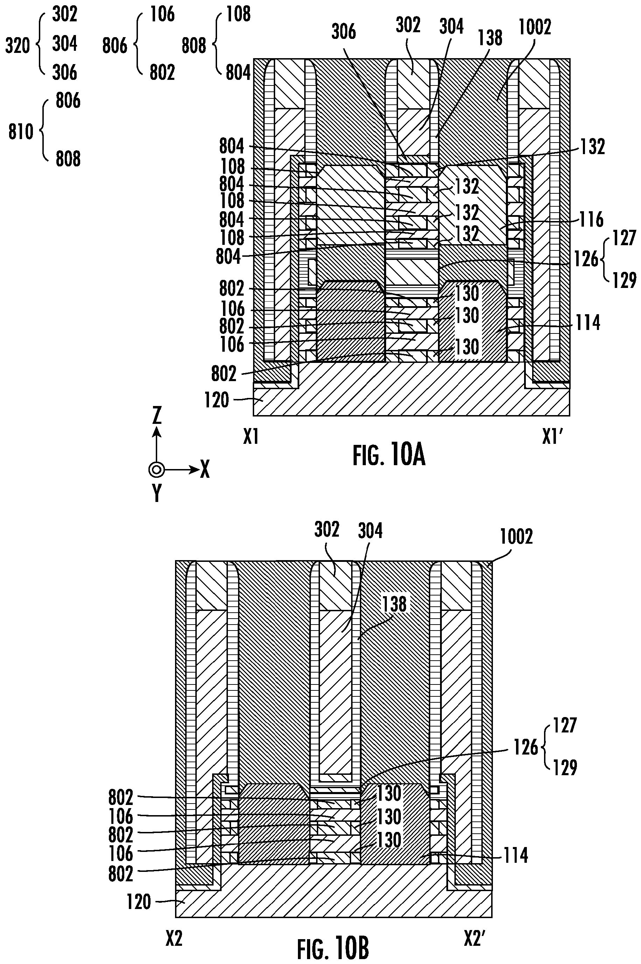

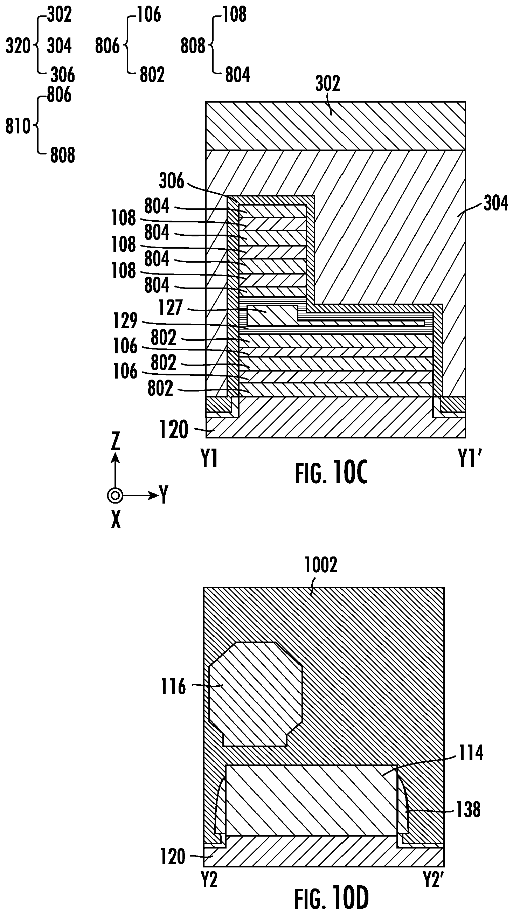

As shown in FIGS. 10A to 10D, lower source/drain regions 114 and upper source/drain regions 116 may be formed (Block 212). The lower source/drain regions 114 may be formed on sidewalls of the lower channel regions 106, respectively. For example, the lower source/drain regions 114 may be epitaxially grown from the lower channel regions 106. In some embodiments, the lower channel regions 106 may include silicon (Si), and the lower source/drain regions 114 may include silicon, silicon carbide, or silicon germanium.

Likewise, upper source/drain regions 116 may be formed on sidewalls of the upper channel regions 108, respectively. For example, the upper source/drain regions 116 may be epitaxially grown from the upper channel regions 108. In some embodiments, the upper channel regions 108 may include silicon (Si), and the upper source/drain regions 116 may include silicon, silicon carbide, or silicon germanium. An insulating layer 1002 may be formed on the lower source/drain regions 114 and the upper source/drain regions 116.

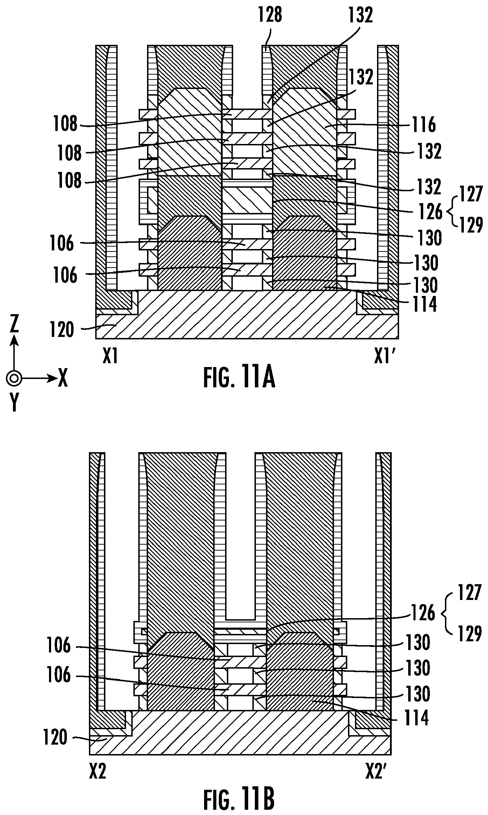

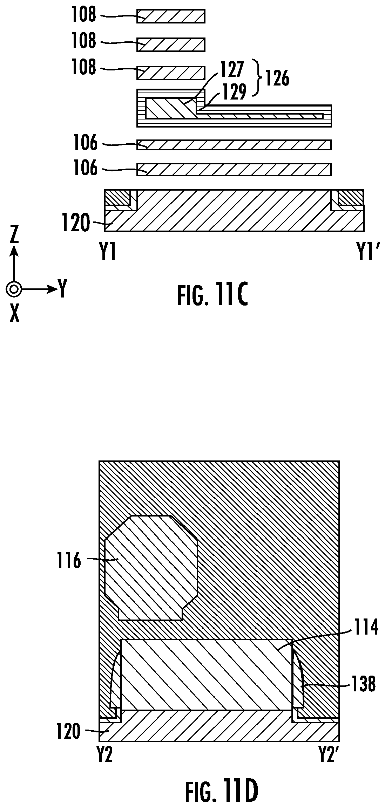

The methods may include forming a lower gate structure and an upper gate structure (e.g., the lower gate structure 110 and the upper gate structure 112 in FIG. 1A) (Block 214). As shown in FIGS. 11A to 11D, the dummy gate structures 320 may be removed by an etching process. A portion of the first spacers 138 (e.g., an upper portion of the first spacers 138) may be removed by an etching process to form the gate spacer 128. The upper sacrificial patterns 804 and the lower sacrificial patterns 802 may be removed by an etch process.

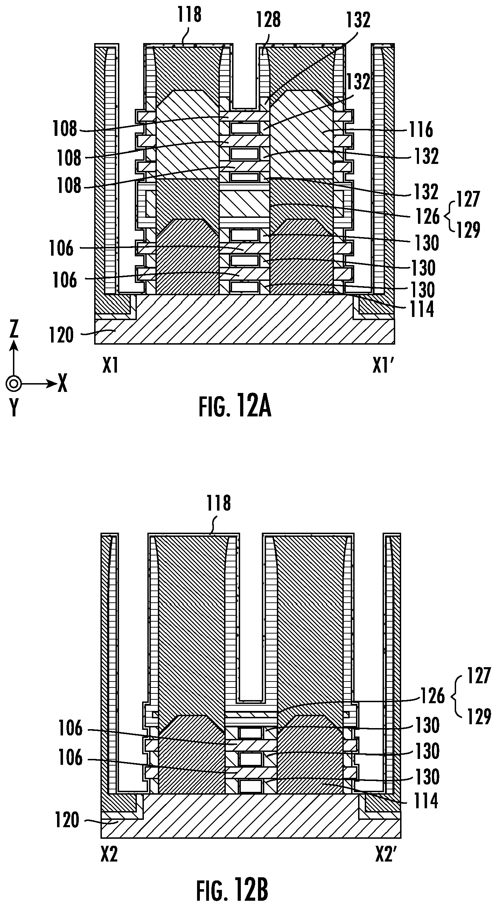

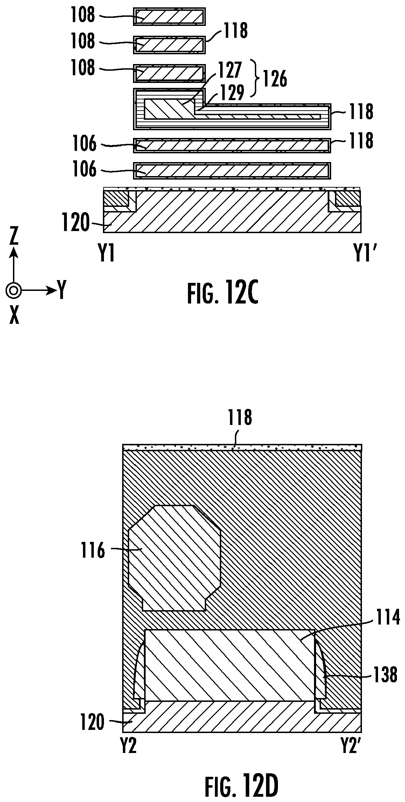

As shown in FIGS. 12A to 12D, a gate insulator 118 may be formed on surfaces exposed by the prior etching processes. The gate insulator 118 may have a uniform thickness along those exposed surfaces and may contact those exposed surfaces.

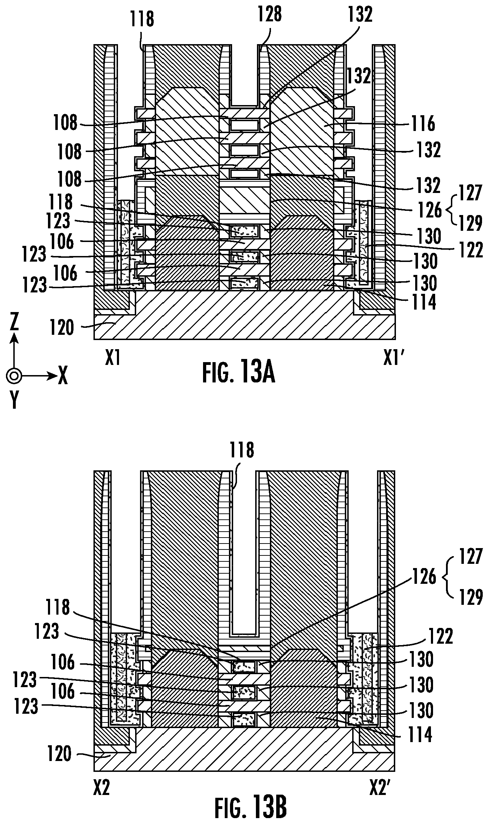

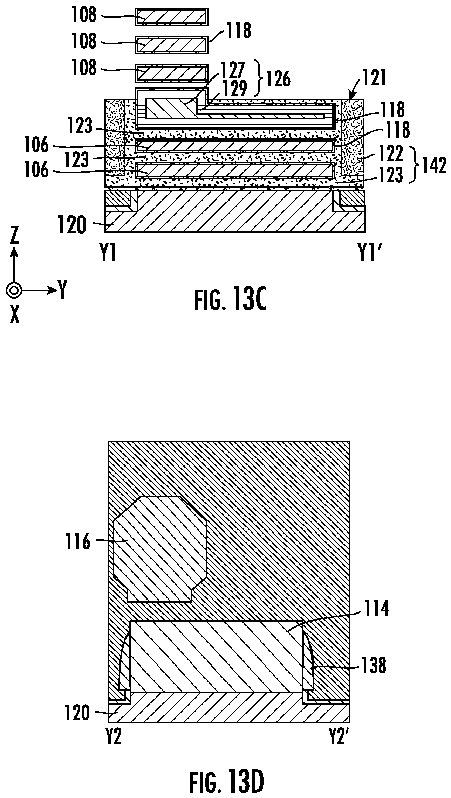

As shown in FIGS. 13A to 13D, a lower work function layer 123 may be formed on the gate insulator 118 adjacent to the lower source/drain region 114. A lower gate metal 122 may be formed on the lower work function layer 123 and the lower channel regions 106. A lower portion of the integrated insulator 126 may be provided in the lower gate electrode 142 that may include the lower work function layer 123 and the lower gate metal 122. An upper portion of the integrated insulator 126 may protrude upwardly beyond the upper surface 121 of the lower gate electrode 142, as illustrated in FIG. 13C. In some embodiments, an upper surface of the lower work function layer 123 and an upper surface of the lower gate metal 122 may be at the same height from the substrate 120, as illustrated in FIG. 13C.

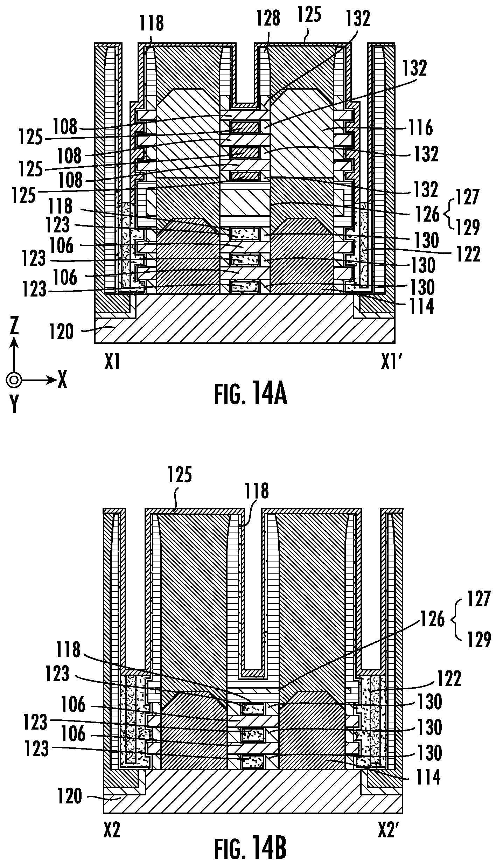

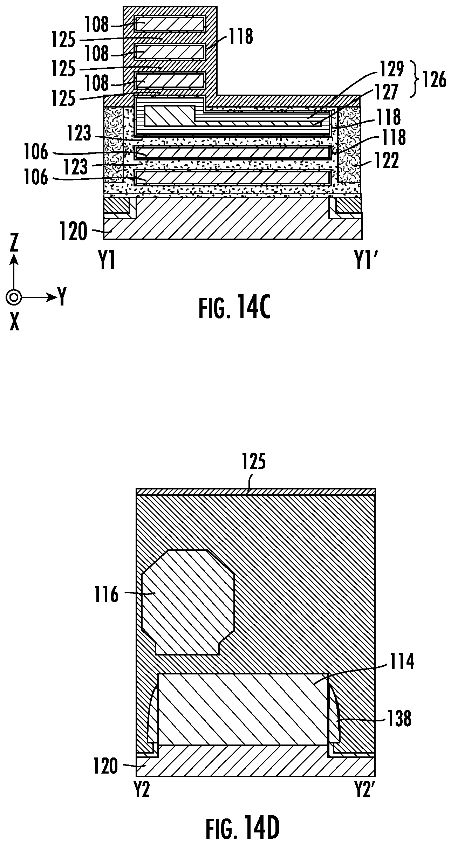

As shown in FIGS. 14A to 14D, an upper work function layer 125 may be formed on the gate insulator 118 adjacent to the upper source/drain region 116. The upper work function layer 125 may contact the lower gate electrode 142 (e.g., the upper surface of the lower gate metal 122 and the upper surface of the lower work function layer 123). Referring back to FIGS. 1A to 1D, an upper gate metal 124 may be formed on the upper work function layer 125 and the upper channel regions 108. An upper portion of the integrated insulator 126 may be provided in the upper gate electrode 144 that may include the upper work function layer 125 and the upper gate metal 124.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

As used herein, "a lower surface" refers to a surface facing a substrate (e.g., the substrate 120 in FIG. 1A), and "an upper surface" refers to a surface opposite the lower surface. Further, as used herein, "a lower portion" refers to a portion that is closer than "an upper portion" to the substrate.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. An integrated circuit device comprising:
an upper transistor that is on a substrate and comprises an upper channel region;
a lower transistor that is between the substrate and the upper transistor and comprises a lower channel region; and
an integrated insulator that is between the lower channel region and the upper channel region and comprises an outer layer and an inner layer in the outer layer,
wherein the inner layer and the outer layer comprise different materials.

2. The integrated circuit device of Claim 1, wherein the upper channel region comprises a plurality of upper channel regions, and
the upper transistor further comprises:
an upper source/drain region contacting the plurality of upper channel regions;
an upper gate structure on the plurality of upper channel regions; and
an upper inner spacer layer that is between the upper source/drain region and the upper gate structure and is between the plurality of upper channel regions,
wherein the upper inner spacer layer comprises a material different from the outer layer.

3. The integrated circuit device of Claim 2, wherein the upper transistor further comprises a gate spacer on a side surface of an upper portion of the upper gate structure,
the upper inner spacer layer is between the integrated insulator and the gate spacer, and
the gate spacer and the outer layer comprises a same material.

4. The integrated circuit device of Claim 3, wherein the gate spacer contacts the upper gate structure.

5. The integrated circuit device of Claim 3 or 4, wherein the gate spacer and the outer layer comprise SiBCN or SiOCN.

6. The integrated circuit device of any one of Claims 2 to 5, wherein the upper inner spacer layer contacts the outer layer of the integrated insulator.

7. The integrated circuit device of any one of Claims 2 to 6, wherein the upper inner spacer layer and the inner layer comprise a same material.

8. The integrated circuit device of any one of Claims 2 to 7, wherein the lower channel region comprises a plurality of lower channel regions, and
the lower transistor further comprises:
a lower source/drain region contacting the plurality of lower channel regions;
a lower gate structure on the plurality of lower channel regions; and
a lower inner spacer layer that is between the lower source/drain region and the lower gate structure and is between the plurality of lower channel regions,
wherein the lower inner spacer layer comprises a material different from the outer layer.

9. A method of forming an integrated circuit device, the method comprising:
forming an upper channel region of an upper transistor on a substrate;
forming a lower channel region of a lower transistor, wherein the lower transistor is between the substrate and the upper transistor; and
forming an integrated insulator, wherein the integrated insulator is between the lower channel region and the upper channel region and comprises an outer layer and an inner layer,
wherein the inner layer and the outer layer comprise different materials.

10. The method of Claim 9, wherein forming the upper channel region, the lower channel region, and the integrated insulator comprises:
forming a preliminary stack structure, a dummy gate structure, and first spacers, wherein the preliminary stack structure comprises a lower channel layer, an upper channel layer and a preliminary integrated insulator between the lower channel layer and the upper channel layer, the preliminary integrated insulator comprises a preliminary inner layer and a preliminary outer layer enclosing the preliminary inner layer, the dummy gate structure traverses the preliminary stack structure, and the first spacers are on opposing side surfaces of the dummy gate structure; and
patterning the preliminary stack structure using the dummy gate structure and the first spacers as an etch mask, thereby forming a stack structure that includes the upper channel region, the lower channel region, and the integrated insulator.

11. The method of Claim 10, wherein forming the stack structure, the dummy gate structure and the first spacers further comprises:
forming the preliminary stack structure that includes the lower channel layer, the upper channel layer and an intergate sacrificial layer that is between the lower channel layer and the upper channel layer;
forming the dummy gate structure traversing the preliminary stack structure;
forming a first opening by removing the intergate sacrificial layer;
forming a first spacer layer on the preliminary stack structure and the dummy gate structure and in the first opening, wherein a portion of the first spacer layer formed in the first opening forms the preliminary outer layer and defines a second opening therein;
forming a second spacer layer on the first spacer layer and in the second opening,
wherein a portion of the second spacer layer formed in the second opening forms the preliminary inner layer;
exposing the first spacer layer by removing the second spacer layer; and
forming the first spacers by etching the first spacer layer.

12. The method of Claim 11, wherein the second spacer layer contacts the first spacer layer and comprises a material different from the first spacer layer.

13. The method of Claim 12, wherein the first spacer layer comprises SiBCN or SiOCN.

14. The method of any one of Claims 11 to 13, wherein the lower channel layer comprises a plurality of lower channel layers, and the upper channel layer comprises a plurality of upper channel layers,
the preliminary stack structure further comprises a plurality of lower sacrificial layers stacked alternately with the plurality of lower channel layers and a plurality of upper sacrificial layers stacked alternately with the plurality of upper channel layers, and
patterning the preliminary stack structure forms the stack structure that includes a lower stack, an upper stack and the integrated insulator between the lower stack and the upper stack, wherein the lower stack comprises a plurality of lower channel regions stacked alternately with a plurality of lower sacrificial patterns, and the upper stack comprises a plurality of upper channel regions stacked alternately with a plurality of upper sacrificial patterns.

15. The method of Claim 14, further comprising:
removing the plurality of lower sacrificial patterns and the plurality of upper sacrificial patterns;
forming a lower gate electrode on the plurality of lower channel regions and a lower portion of the integrated insulator, wherein an upper portion of the integrated insulator protrudes upwardly beyond an upper surface of the lower gate electrode; and
forming an upper gate electrode on the plurality of upper channel regions and the upper portion of the integrated insulator.
